# EUROPÄISCHE PATENTSCHRIFT

(11) **EP 4 052 290 B1**
(45) Veröffentlichungstag und Bekanntmachung des Hinweises auf die Patenterteilung: **14.02.2024**
(21) Anmeldenummer: 20800079.4
(22) Anmeldetag: 28.10.2020
(51) Int. Cl.: H01L 21/673

(54) **MAGAZINSYSTEM**
MAGAZINE SYSTEM
SYSTÈME DE MAGASIN

(30) Priorität: 31.10.2019 DE 102019216864
(43) Veröffentlichungstag der Anmeldung: 07.09.2022
(73) Patentinhaber: ASYS Automatisierungssysteme GmbH, 89160 Dornstadt (DE)
(72) Erfinder: VEGELAHN, Torsten, 75447 Sternenfels (DE); LEHNER, Jürgen, 89150 Laichingen (DE)
(74) Vertreter: Clarenbach, Carl-Philipp
(86) Internationale Anmeldenummer: PCT/EP2020/080317
(87) Internationale Veröffentlichungsnummer: WO 2021/083971

(56) Entgegenhaltungen:
- US-A- 4 453 785
- US-A- 5 255 970
- US-A- 5 638 958
- US-A1- 2007 062 889
- US-A1- 2013 256 186
- US-A1- 2016 368 145

## Beschreibung

Die Erfindung betrifft ein Magazinsystem für Fertigungslinien von flächigen Substraten, insbesondere Wafer, Solarzellen oder Leiterplatten, mit zumindest einem Substratmagazin, das zwei einander gegenüberliegend angeordnete und vertikal ausgerichtete Seitenwände aufweist sowie eine Vielzahl von zwischen den Seitenwänden ausgebildete Schubfächer, in welche jeweils ein oder mehrere Substrate einschiebbar sind, wobei jedes Schubfach zwei beabstandet und parallel zueinander an den Seitenteilen angeordnete Führungsschienen aufweist.

Magazinsysteme der eingangs genannten Art sind aus dem Stand der Technik bekannt. Bei der Fertigung von Wafern, Solarzellen, Leiterplatten oder anderen flächigen Substraten werden die Substrate häufig zur Zwischenlagerung oder für den Transport in Substratmagazinen abgelegt. Dabei wurden Substratmagazine zunächst derart gefertigt, dass an zwei einander gegenüberliegenden Seitenwänden jeweils eine Vielzahl von parallel zueinander angeordnete Führungsschienen angeordnet sind, die in der Höhe beabstandet zueinander liegen, wobei jeweils zwei auf einer Höhe liegende Führungsschienen, die an den einander gegenüberliegenden Seitenwänden angeordnet sind, zusammen ein Schubfach für ein Substrat bilden. Das Substrat ist dabei einfach auf die Führungsschienen in das Substratmagazin einschiebbar und durch Verschieben auch wieder aus dem Substratmagazin entnehmbar. Aus der noch nicht veröffentlichten Patentanmeldung DE 10 2019 211 603 ist außerdem ein Substratmagazin bekannt, bei welchem in einem Schubfach mehrere Substrate nebeneinanderliegend vorteilhaft anordenbar sind. Dazu sind den Führungsschienen jeweils Rastmittel zugeordnet, die im Bewegungsweg der Substrate entlang der Führungsschienen liegen und durch die Substrate unter elastischer Verformung aus dem Bewegungsweg heraus bewegbar sind. Somit sind die Substrate auf den Führungsschienen verschiebbar und die Rastelemente durch Aufwenden einer entsprechenden Schubkraft überwindbar. Durch die Rastelemente wird erreicht, dass die Substrate sich nicht ungewollt entlang der Führungsschienen verschieben. Insbesondere wird dadurch verhindert, dass benachbarte Substrate versehentlich, beispielsweise beim Transport des Substratmagazins, übereinander geschoben werden.

Aus der Offenlegungsschrift US 2007/062889 A1 ist ein gattungsgemäßes Magazinsystem mit den Merkmalen des Oberbegriffs des Anspruchs 1 bekannt. Ein weiteres Magazinsystem ist aus der Offenlegungsschrift US 2013/256186 A1 bekannt.

Der Erfindung liegt die Aufgabe zugrunde, ein verbessertes Magazinsystem zu schaffen, das eine höhere Flexibilität und Verwendbarkeit des Magazinsystems erlaubt.

Die der Erfindung zugrundeliegende Aufgabe wird durch ein Magazinsystem mit den Merkmalen des Anspruchs 1 gelöst. Dieses hat den Vorteil, dass das Magazinsystem derart anpassbar ist, dass es nicht nur für flächige Substrate, sondern auch für Substratstapel, also für eine Vielzahl aufeinander gestapelter Substrate, als Lagerstelle dienen kann. Durch das erfindungsgemäße Magazinsystem wird erreicht, dass ein bestehendes Substratmagazin auf einfache Art und Weise derart angepasst werden kann, dass zwischen dem Betrieb für die Aufnahme von einzelnen Substraten in einen Betrieb für die Aufnahme von Substratstapeln gewechselt werden kann. Erfindungsgemäß wird dies dadurch erreicht, dass das Magazinsystem für jede der Seitenwände zumindest eine Adapterplatte aufweist, wobei die jeweilige Adapterplatte Befestigungsmittel zum lösbaren Befestigen an einer der Seitenwände aufweist, und wobei die Adapterplatten auf jeweils einer Seite jeweils eine oder mehrere Tragschienen aufweisen, die im befestigen Zustand an den Seitenwänden zusammen jeweils eine Auflage für einen Substratstapel bilden. Die Seitenwände können somit durch die Adapterplatten zur Aufnahme von Substratstapeln adaptiert werden. Dazu sind die Adapterplatten lösbar an den Seitenwänden befestigbar und weisen ihrerseits Tragschienen auf. Diese Tragschienen liegen im montierten Zustand der Adapterplatten an den Seitenwänden einander gegenüber und auf gleicher Höhe, sodass sie zusammen eine Auflage für einen Substratstapel bilden. Dadurch ist mit wenigen Hilfsmitteln und wenigen Schritten eine Anpassung des Substratmagazins auf Einzelsubstrate oder Substratstapel ermöglicht.

Gemäß einer bevorzugten Weiterbildung der Erfindung weist jede Adapterplatte zumindest einen Montagehaken zum Einhängen an der jeweiligen Seitenwand auf. Das Einhängen der jeweiligen Adapterplatte erlaubt eine einfache Montage an den Seitenwänden und einen sicheren Halt. Darüber hinaus erlaubt das Einhängen auch eine einfache Demontage der Adapterplatten, indem die Montagehaken aus der jeweiligen Seitenwand ausgehängt werden. Gemäß einer Ausführungsform wird auf weitere Befestigungsmittel verzichtet.

Gemäß einer weiteren Ausführungsform der Erfindung weist jede Adapterplatte zumindest ein elastisch verlagerbares Rastelement zum formschlüssigen Arretieren an der Seitenwand zusätzlich oder alternativ zu dem bereits genannten Montagehaken auf. Durch das Rastelement ist ein ungewolltes Lösen von der jeweiligen Seitenwand sicher verhindert. Im Unterschied zu dem Einhaken erlaubt die Verwendung des Rastelements außerdem eine einfache translatorische Montagefügung oder -bewegung, während das Einhaken auch ein Verschwenken der Adapterplatte bedingt. Je nach Bauraum oder Ausbildung des Substratmagazins kann sich eine rein translatorische Montagebewegung als Vorteil erweisen.

Besonders bevorzugt weist jede Adapterplatte an einem ersten Ende den zumindest einen Montagehaken und an dem von dem ersten Ende abgewandten zweiten Ende das zumindest eine Rastelement auf. Damit ist die jeweilige Adapterplatte an dem einen Ende an der jeweiligen Seitenwand einhängbar und an dem anderen Ende durch das Rastelement formschlüssig an der Seitenwand arretierbar. Dadurch ist ein ungewolltes Lösen der Leiterplatte sicher verhindert. Darüber hinaus erlaubt die Befestigung auch, dass Klappergeräusche oder Bewegungen der Adapterplatte bei einer Bewegung des Substratmagazins verhindert werden. Optional sind dem Montagehaken und/oder dem jeweiligen Rastelement elastische Dämpfungsmittel zugeordnet, die zwischen der Adapterplatte und der jeweiligen Seitenwand wirken, um Klappergeräusche und Bewegungen zu vermeiden. Optional sind die Dämpfungselemente bei bestimmungsgemäßer Anordnung der Adapterplatte an einer Seitenwand elastisch verformt beziehungsweise vorgespannt, sodass eine besonders feste Anordnung der jeweiligen Adapterplatte an der jeweiligen Seitenwand gewährleistet ist.

Gemäß einer vorteilhaften Weiterbildung der Erfindung sind an jeder Adapterplatte mehrere Tragschienen parallel zueinander angeordnet, wobei benachbarte Tragschienen der jeweiligen Adapterplatte einen Abstand zueinander aufweisen, der größer ist als ein Abstand benachbarter Führungsschienen zueinander. Durch den vergrößerten Abstand wird die Aufnahme von Substratstapeln ermöglicht. Durch das Vorhandensein mehrerer Tragschienen ist gewährleistet, dass mittels der Adapterplatten in dem Substratmagazin mehrere Substratstapel aufgenommen werden können. Unter dem Abstand der benachbarten Tragschienen oder Führungsschienen ist dabei der Abstand der Schienen in der Höhe bei bestimmungsgemäßer Anordnung der Adapterplatten an der jeweiligen Seitenwand zu verstehen.

Gemäß einer bevorzugten Weiterbildung der Erfindung bilden die an dem Substratmagazin angeordneten Adapterplatten zumindest zwei übereinanderliegende Tragfächer auf. Somit weisen zumindest zwei Adapterplatten des Magazinsystems jeweils zwei Tragschienen auf, die bei bestimmungsgemäßem Gebrauch einander auf gleicher Höhe gegenüberliegen, sodass zwei Tragfächer geschaffen sind.

Weiterhin ist bevorzugt vorgesehen, dass die jeweilige Adapterplatte als Adapterblech ausgebildet und die jeweilige Tragschiene als freigestellte und herausgebogene Blechzunge in dem Adapterblech ausgebildet ist. Durch die Ausbildung der jeweiligen Adapterplatte als Adapterblech ist eine konstruktiv einfache und kostengünstige Realisierung der Adapterplatten gewährleistet. Durch das Herausbiegen der Tragschienen als Blechzungen ist darüber hinaus die Anzahl der Einzelteile des Magazinsystems minimiert. Optional sind die Tragschienen selbst lösbar an der jeweiligen Adapterplatte gehalten. Dadurch wird erreicht, dass die Tragfächer der Adapterplatten an zu erwartende Substratstapel anpassbar sind. So ist beispielsweise der Höhenabstand der Tragschienen an einer Adapterplatte insbesondere in mehreren Stufen wählbar, um das Substratmagazin zur Aufnahme vor bestimmten Substratstapelgrößen vorzubereiten.

Weiterhin ist bevorzugt vorgesehen, dass der jeweiligen Tragschiene elastisch verlagerbare, insbesondere elastisch verformbare Rückhaltemittel für einen Substratstapel zugeordnet sind. Die Rückhaltemittel befinden sich in dem Substratstapel in dem jeweiligen Substratmagazin und können durch das Aufbringen einer ausreichenden Schubkraft auf den jeweiligen Substratstapel in eine Freigabeposition verformt oder verlagert werden. Bei den Rückhaltemitteln handelt es sich beispielsweise um elastische Rastnasen, die im unbelasteten Zustand in den Bewegungsweg des Substratstapels entlang der jeweiligen Tragschiene liegen. Insbesondere sind jedem Tragfach mehrere Rückhaltemittel derart zugeordnet, dass auch zwei oder mehr Substratstapel beabstandet zueinander nebeneinander in dem jeweiligen Tragfach anordenbar sind und durch die Rückhaltemittel auf Abstand zueinander gehalten werden.

Weiterhin ist bevorzugt vorgesehen, dass zumindest eine Seitenwand des Substratmagazins derart verschiebbar gelagert ist, dass eine lichte Weite zwischen den Seitenwänden veränderbar ist. Dadurch ist eine Anpassung der lichten Weite zwischen den optional an den Seitenwänden angeordneten Adapterplatten ebenfalls möglich. Damit wird gewährleistet, dass in einem und demselben Substratmagazin sowohl Substratstapel als auch Einzelsubstrate dieses Substratstapels sicher aufgenommen und transportiert werden können.

Bevorzugt weist jede Seitenwand zumindest eine Öffnung oder Aufnahme für zumindest einen Montagehaken auf. In die jeweilige Öffnung ist der jeweilige Montagehaken einführbar und einhängbar. Durch die vorgesehene Öffnung oder Aufnahme wird eine Fehlmontage der Adapterplatten an der jeweiligen Seitenwand vermieden.

Besonders bevorzugt weist jede Seitenwand zumindest ein Gegenrastelement zum Zusammenwirken mit dem Rastelement einer Adapterplatte auf. Beispielsweise handelt es sich bei dem Rastelement um einen elastisch verlagerbaren Rastvorsprung oder um eine Rastvorsprungsaufnahme, und bei dem Gegenrastelement um eine Rastvorsprungaufnahme oder einen elastisch verformbaren oder verlagerbaren Rastvorsprung, wobei der Rastvorsprung und die Rastvorsprungaufnahme dazu ausgebildet sind, einen lösbaren Hintergriff zur formschlüssigen Verbindung zu bilden.

Weiterhin ist bevorzugt vorgesehen, dass das zumindest eine Rastelement der Adapterplatte einstückig mit der Adapterplatte ausgebildet ist. So wird das Rastelement insbesondere als weitere herausgebogene Blechzunge der Adapterplatte ausgebildet, wodurch die Teileanzahl weiter minimiert und eine einfache Montage der jeweiligen Adapterplatte gewährleistet ist.

Insbesondere ist auch der zumindest eine Montagehaken einstückig mit der jeweiligen Adapterplatte ausgebildet, wodurch sich eine insgesamt einfache Montage und Herstellung des Magazinsystems ergibt.

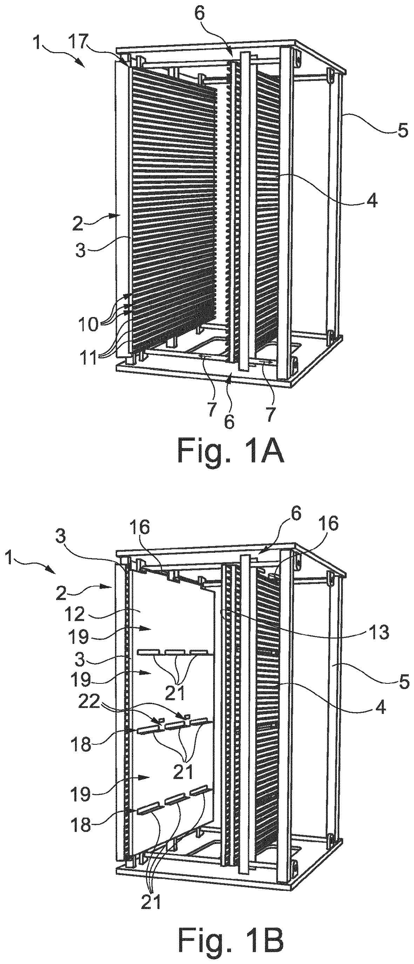

Im Folgenden soll die Erfindung anhand der Zeichnungen näher erläutert werden. Dazu zeigen Figuren 1A und 1B ein vorteilhaftes Substratmagazinsystem in unterschiedlichen Zuständen,
- Figur 2: eine Adapterplatte des Magazinsystems in einer perspektivischen Darstellung und
- Figur 3: zwei Adapterplatten des Magazinsystems in einer perspektivischen Draufsicht.

Figuren 1A und 1B zeigen jeweils ein vorteilhaftes Magazinsystem 1 für flächige Substrate, die sowohl einzeln als auch als Substratstapel gehandhabt werden können. Das Magazinsystem 1 weist ein Substratmagazin 2 auf, das zwei einander gegenüberliegend angeordnete Seitenwände 3, 4 aufweist, die parallel zueinander vertikal in einem Rahmen 5 angeordnet sind. Die Seitenwand 3 ist dabei gemäß dem vorliegenden Ausführungsbeispiel fest in dem Rahmen 5 angeordnet, während die gegenüberliegende Seitenwand 4 durch ein Schienensystem 6 quer-verschieblich in dem Rahmen 5 gehalten ist, sodass durch ein Verschieben der Seitenwand 4 gemäß Pfeile 7 eine lichte Weite zwischen den Seitenwänden 3, 4 veränderbar ist. Zwischen den Seitenwänden sind eine Vielzahl von übereinanderliegend angeordneter Schubfächer 10 ausgebildet, deren Breite durch ein Verschieben der Seitenwand 4 veränderbar ist. Die Schubfächer 10 werden dabei durch an der jeweiligen Seitenwand 3, 4 angeordnete Führungsschienen 11 gebildet, die gleichmäßig in der Höhe beabstandet zueinander parallel zueinander ausgerichtet sind, wobei jeweils zwei Führungsschienen 11 an den Seitenwänden 3, 4 auf dergleichen Höhe liegen, sodass sie zusammen eine Schiebeauflage für ein einzelnes flächiges Substrat, wie beispielsweise eine Leiterplatte, Wafer oder Solarzelle, bilden. Die jeweils darüberliegenden Führungsschienen 11 begrenzen den Laderaum der darunterliegenden Schiebeaufnahme in der Höhe und bilden somit mit den darunterliegenden Führungsschienen 11 jeweils ein Schubfach 10 aus.

Figur 1B zeigt das Magazinsystem 1 in einem weiteren Zustand. An dem Substratmagazin 2 sind zwei Adapterplatten 12, 13 angeordnet, die dazu dienen, das Substratmagazin 2 darauf anzupassen, Substratstapel der flächigen Substrate aufzunehmen. Unter einem Substratstapel wird dabei eine Vielzahl von direkt aufeinander gestapelten Einzelsubstraten verstanden, die zusammen gehandhabt werden. Insbesondere sind die Einzelsubstrate dabei in dem Substratstapel bündig zueinander ausgerichtet, sodass die Außenkontur des Substratstapels der Außenkontur eines Einzelsubstrats entspricht, wobei die Höhe des Substratstapels durch die Anzahl der übereinanderliegenden Einzelsubstrate bestimmt ist.

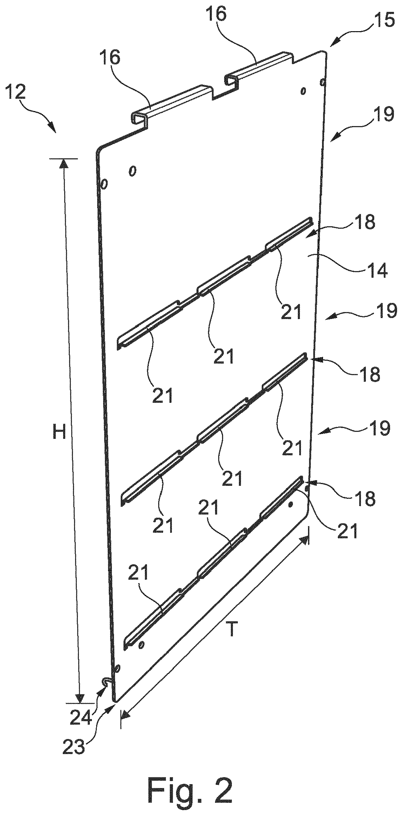

Die Adapterplatten 12, 13 sind insbesondere gleich, vorzugsweise identisch, ausgebildet. Figur 2 zeigt zur Erläuterung der Adapterplatten 12, 13 die Adapterplatte 12 in einer perspektivischen Darstellung. Die Adapterplatte 12 ist als Adapterblechplatte 14 ausgebildet, deren Höhe H zumindest im Wesentlichen der Höhe der jeweiligen Seitenwand 3, 4 entspricht, und deren Tiefe T der Tiefe der Seitenwände 3, 4 zumindest im Wesentlichen entspricht. Die Adapterplatte 12 weist an ihrem oberen Ende 15 zwei nebeneinander angeordnete Montagehaken 16 als Befestigungsmittel zur Befestigung an der jeweiligen Seitenwand 3, 4 auf. Die Montagehaken 16 sind dazu ausgebildet, den oberen Rand 17 der Seitenwand 3 zu hintergreifen, sodass die Adapterplatte 12 an der Seitenwand 3 anhängbar ist, wie in Figur 1B gezeigt.

Weiterhin weist die Adapterplatte 12 mehrere Tragschienen 18 auf, die parallel zueinander ausgerichtet sind. Die Tragschienen 18 erstrecken sich dabei in der Tiefenerstreckung der Adapterplatte 12 und weisen einen Abstand zueinander auf, der größer ist als der Abstand benachbarter Führungsschienen 11 der Seitenwände 3, 4 in Richtung der Höhe H. Insbesondere sind die Abstände zwischen den benachbarten Tragschienen 18 derart gewählt, dass durch jede Tragschiene 18 ein Tragfach 19 zur Aufnahme eines Substratstapels mit einer vorbestimmten Maximalanzahl von Einzelsubstraten bereitgestellt ist.

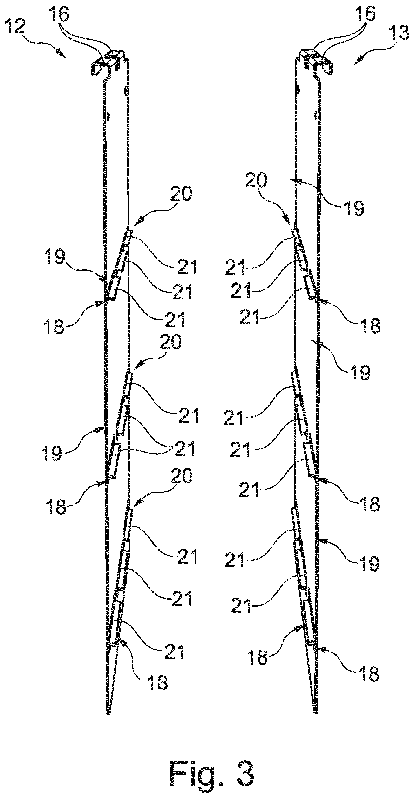

Figur 3 zeigt die zwei Adapterplatten 12, 13 in einer perspektivischen Draufsicht. Durch die gleiche Ausbildung der Adapterplatten 12, 13 liegen die Tragschienen 18 bei bestimmungsgemäßer Montage an dem Substratmagazin 2 in gleicher Höhe, sodass zwei einander gegenüberliegende Tragschienen 18 jeweils eine Aufnahme 20 für den jeweiligen Substratstapel bildet.

Gemäß dem vorliegenden Ausführungsbeispiel erstrecken sich die Tragschienen 18 nicht durchgehend über das jeweilige Adapterblech, sondern sind in ihrer Längserstreckung unterbrochen ausgebildet. Insbesondere sind die Tragschienen 18 jeweils durch mehrere aus dem Adapterblech freigestellte, insbesondere freigeschnittene, und herausgebogene Blechzungen 21 gebildet.

Vorzugsweise sind auch die Montagehaken 16 als umgebogene Blechabschnitte der jeweiligen Adapterplatte 12 ausgebildet, sodass die Adapterplatte 12 insgesamt einteilig ausgebildet ist, wodurch die Einzelteilezahl minimiert und Herstellungskosten und Montageaufwand reduziert werden.

Die jeweilige Adapterplatte 12, 13 ist mit dem jeweiligen Montagehaken 16 an der jeweiligen Seitenwand 3 oder 4 montierbar, wie in Figur 1B gezeigt, sodass sich die Tragschienen 18 der gegenüberliegenden Adapterplatten 12, 13 auf einer Höhe gegenüberliegen und das jeweilige Tragfach 19 beziehungsweise die jeweilige Aufnahme 20 für einen Substratstapel bilden. Die Anzahl der Tragschienen 18 ist deutlich geringer als die Anzahl der Führungsschienen 11, sodass, wie zuvor bereits erwähnt, der Abstand in der Höhe benachbarter Tragschienen 18 vergrößert ist und zur Aufnahme eines Leiterplattenstapels beziehungsweise Substratstapels vorteilhaft geeignet ist.

Dadurch, dass die Seitenwand 3 verschieblich gelagert ist, ist auch die lichte Weite zwischen den Adapterplatten 12, 13 einstellbar. Damit ist es möglich, mit ein und demselben Substratmagazin 2 sowohl einzelne Substrate in den Schubfächern 10 aufzunehmen und seitlich an deren Randbereich mittels der Führungsschienen 11 sicher zu lagern, als auch Substratstapel der gleichen Substrate, die dann auf den Tragschienen 18 anordenbar sind. Hierzu wird die Seitenwand 4 lediglich ein Stück weit von der Seitenwand 3 entfernt, sodass die leichte Weite zwischen den Tragwänden 12, 13 der vorherigen lichten Weite zwischen den Seitenwänden 3, 4 entspricht.

Optional sind den Tragschienen 18 Rückhaltemittel 22 zugeordnet, wie beispielhaft mit Figur 1B für eine der Tragschienen 18 gezeigt, die im entspannten Zustand im Schiebeweg von einem Substratstapel entlang der Tragschiene 18 liegen. Die Rückhaltemittel 22 sind beispielsweise als elastisch verlagerbare Rastnasen ausgebildet, die durch einen Substratstapel unter elastischer Verformung aus dem Bewegungsweg gedrückt werden können, wenn eine ausreichend hohe Schubkraft aufgebracht wird. Die Rückhaltemittel 22 sichern den jeweiligen Substratstapel in dem Substratmagazin 2 vor einem ungewollten Verschieben oder Verlagern. Insbesondere sind auch den Führungsschienen 10 jeweils wenigstens ein, vorzugsweise mehrere derartige Rückhaltemittel zugeordnet, die es erlauben, dass mehrere Substrate in einem Schubfach 10 nebeneinanderliegend gehalten sind, sodass ein Übereinanderschieben oder Gegeneinanderschieben bei einem Bewegen des Substratmagazins 2 verhindert ist.

Optional weisen die Adapterplatten 12, 13 außerdem insbesondere an ihren von dem Montagehaken 16 abgewandten zweiten Ende 23 einen oder mehrere elastisch verformbare Rastelemente 24 in Form von Rasthaken auf, die in eine Rastöffnung der jeweiligen Seitenwand 3, 4 unter elastischer Verformung derart einbringbar sind, dass sie im montierten Zustand die jeweilige Seitenwand 3, 4 formschlüssig hintergreifen. Dadurch sind die Adapterplatten 12, 13 besonders sicher an den Seitenwänden 3, 4 befestigbar.

Das Magazinsystem 1 weist vorzugsweise eine Vielzahl von Paaren von Adapterplatten 12, 13 auf, wobei sich die Paare von Adapterplatten beispielsweise in der Anzahl und dem Abstand der Tragschienen 18 zueinander unterscheiden. Dadurch ist eine Anpassung des Substratmagazins 2 in unterschiedliche Substratstapelhöhen ermöglicht.

## Patentansprüche

1. Magazinsystem (1) für Fertigungslinien von flächigen Substraten, insbesondere Wafer, Solarzellen oder Leiterplatten, mit zumindest einem Substratmagazin (2), das zwei einander gegenüberliegend angeordnete und vertikal ausgerichtete Seitenwände (3,4) aufweist sowie eine Vielzahl von zwischen den Seitenwänden (3,4) ausgebildete Schubfächer (10), in welche jeweils ein oder mehrere Substrate einschiebbar sind, wobei jedes Schubfach zwei beabstandet und parallel zueinander an den Seitenteilen (3,4) angeordnete Führungsschienen (11) aufweist, **dadurch gekennzeichnet, dass** das Magazinsystem (1) für jede der Seitenwände (3,4) zumindest eine Adapterplatte (12,13) aufweist, wobei die jeweilige Adapterplatte (12,13) Befestigungsmittel zum lösbaren Befestigen an einer der Seitenwände (3,4) aufweist, und wobei die Adapterplatten (12,13) jeweils auf einer Seite jeweils eine oder mehrere Tragschienen (18) aufweisen, die im befestigten Zustand an den Seitenwänden (3,4) zusammen jeweils eine Auflage (20) für einen Substratstapel bilden.

2. Magazinsystem nach Anspruch 1, **dadurch gekennzeichnet, dass** jede Adapterplatte (12,13) zumindest einen Montagehaken (16) zum Einhängen an der jeweiligen Seitenwand (3,4) aufweist.

3. Magazinsystem nach einem der vorhergehenden Ansprüche, **dadurch gekennzeichnet, dass** jede Adapterplatte (12,13) zumindest ein elastisch verlagerbares Rastelement (24) zum formschlüssigen Arretieren an der jeweiligen Seitenwand (3,4) aufweist.

4. Magazinsystem nach einem der vorhergehenden Ansprüche, **dadurch gekennzeichnet, dass** jede Adapterplatte (12,13) an einem ersten Ende (15) den zumindest einen Montagehaken (16) und an dem von dem ersten Ende (15) abgewandten zweiten Ende (23) das zumindest eine Rastelement (24) aufweist.

5. Magazinsystem nach einem der vorhergehenden Ansprüche, **dadurch gekennzeichnet, dass** an jeder Adapterplatte (12,13) mehrere Tragschienen (18) parallel zueinander angeordnet sind, wobei benachbarte Tragschienen (18) einen Abstand zueinander aufweisen, der größer ist als ein Abstand der benachbarten Führungsschienen (11) zueinander.

6. Magazinsystem nach einem der vorhergehenden Ansprüche, **dadurch gekennzeichnet, dass** die an dem Substratmagazin (2) angeordneten Adapterplatten (12,13) zumindest zwei übereinanderliegende Tragfächer (19) der Substratstapel bilden.

7. Magazinsystem nach einem der vorhergehenden Ansprüche, **dadurch gekennzeichnet, dass** die jeweilige Adapterplatte (12,13) als Adapterblech und die jeweilige Tragschiene (18) als zumindest eine freigestellte und herausgebogene Blechzunge (21) in dem Adapterblech ausgebildet ist.

8. Magazinsystem nach einem der vorhergehenden Ansprüche, **dadurch gekennzeichnet, dass** die jeweilige Tragschiene (18) lösbar an der jeweiligen Adapterplatte (12,13) befestigbar oder befestigt ist.

9. Magazinsystem nach einem der vorhergehenden Ansprüche, **dadurch gekennzeichnet, dass** der jeweiligen Tragschiene (18) zumindest ein elastisch verlagerbares, insbesondere verformbares Rückhaltemittel (22) für einen Substratstapel zugeordnet ist.

10. Magazinsystem nach einem der vorhergehenden Ansprüche, **dadurch gekennzeichnet, dass** zumindest eine Seitenwand (4) des Substratmagazins derart verschiebbar gelagert ist, dass eine lichte Weite zwischen den Seitenwänden (3,4) veränderbar ist.

11. Magazinsystem nach einem der vorhergehenden Ansprüche, **dadurch gekennzeichnet, dass** jede Seitenwand (3,4) zumindest eine Öffnung oder Aufnahme für zumindest einen Montagehaken (16) aufweist.

12. Magazinsystem nach einem der vorhergehenden Ansprüche, **dadurch gekennzeichnet, dass** jede Seitenwand (3,4) zumindest ein Gegenrastelement zum Zusammenwirken mit dem Rastelement (24) der Adapterplatte (12,13) aufweist.

13. Magazinsystem nach einem der vorhergehenden Ansprüche, **dadurch gekennzeichnet, dass** das zumindest eine Rastelement (24) der Adapterplatte (12,13) einstückig mit der Adapterplatte (12,13) ausgebildet ist.

14. Magazinsystem nach einem der vorhergehenden Ansprüche, **dadurch gekennzeichnet, dass** der zumindest eine Montagehaken (16) einstückig mit der Adapterplatte (12,13) ausgebildet ist.

## Claims

1. Magazine system (1) for production lines of flat substrates, in particular wafers, solar cells or printed circuit boards, with at least one substrate magazine (2) which comprises two side walls (3,4) arranged opposite one another and aligned vertically, and a plurality of compartments (10) which are formed between the side walls (3,4) and into each of which one or more substrates can be inserted, wherein each compartment comprises two guide rails (11) arranged at a distance from and parallel to one another on the side parts (3,4), **characterized in that** the magazine system (1) comprises at least one adapter plate (12,13) for each of the side walls (3,4), wherein the respective adapter plate (12,13) comprises fastening means for detachable fastening to one of the side walls (3,4), and wherein the adapter plates (12,13) each comprise one or more support rails (18) on each side, which together form a support (20) for a substrate stack when attached to the side walls (3,4).

2. Magazine system according to claim 1, **characterized in that** each adapter plate (12,13) comprises at least one mounting hook (16) for hanging onto the respective side wall (3,4).

3. Magazine system according to one of the preceding claims, **characterized in that** each adapter plate (12,13) comprises at least one elastically displaceable locking element (24) for form-fitting locking on the respective side wall (3,4).

4. Magazine system according to one of the preceding claims, **characterized in that** each adapter plate (12,13) comprises the at least one mounting hook (16) at a first end (15) and the at least one locking element (24) at the second end (23) facing away from the first end (15).

5. Magazine system according to one of the preceding claims, **characterized in that** a plurality of support rails (18) are arranged parallel to one another on each adapter plate (12,13), wherein adjacent support rails (18) comprise a distance from one another which is greater than a distance of the adjacent guide rails (11) from one another.

6. Magazine system according to one of the preceding claims, **characterized in that** the adapter plates (12,13) arranged on the substrate magazine (2) form at least two superimposed support compartments (19) of the substrate stacks.

7. Magazine system according to one of the preceding claims, **characterized in that** the respective adapter plate (12,13) is designed as a sheet metal adapter and the respective support rail (18) is designed as at least one exposed and bent-out sheet metal tongue (21) in the sheet metal adapter.

8. Magazine system according to one of the preceding claims, **characterized in that** the respective support rail (18) is detachably attachable or attached to the respective adapter plate (12,13).

9. Magazine system according to one of the preceding claims, **characterized in that** at least one elastically displaceable, in particular deformable retention means (22) for a substrate stack is assigned to the respective support rail (18).

10. Magazine system according to one of the preceding claims, **characterized in that** at least one side wall (4) of the substrate magazine is displaceably mounted in such a way that a clear width between the side walls (3,4) can be varied.

11. Magazine system according to one of the preceding claims, **characterized in that** each side wall (3,4) comprises at least one opening or recess for at least one mounting hook (16).

12. Magazine system according to one of the preceding claims, **characterized in that** each side wall (3,4) comprises at least one counter-locking element for interacting with the locking element (24) of the adapter plate (12,13).

13. Magazine system according to one of the preceding claims, **characterized in that** the at least one locking element (24) of the adapter plate (12, 13) is formed integrally with the adapter plate (12,13).

14. Magazine system according to one of the preceding claims, **characterized in that** the at least one mounting hook (16) is formed integrally with the adapter plate (12,13).

## Revendications

1. Système d'entreposage (1) pour des lignes de fabrication de substrats plats, en particulier de plaquettes, de cellules solaires ou de cartes de circuits imprimés, avec au moins un magasin de substrats (2) qui présente deux parois latérales (3, 4) disposées l'une en face de l'autre et orientées verticalement, ainsi qu'une pluralité de tiroirs (10) formés entre les parois latérales (3, 4), dans lesquels un ou plusieurs substrats peuvent respectivement être insérés, chaque tiroir présentant deux glissières (11) espacées et parallèles entre elles sur les parois latérales (3, 4), **caractérisé en ce que** le système d'entreposage (1) présente pour chacune des parois latérales (3, 4) au moins une plaque d'adaptation (12, 13), la plaque d'adaptation (12, 13) respective présentant des moyens de fixation pour la fixation amovible à l'une des parois latérales (3, 4), et les plaques d'adaptation (12, 13) présentant chacune sur un côté un ou plusieurs rails porteurs (18) qui, à l'état fixé sur les parois latérales (3, 4), forment ensemble respectivement un support (20) pour une pile de substrats.

2. Système d'entreposage selon la revendication 1, **caractérisé en ce que** chaque plaque d'adaptation (12, 13) présente au moins un crochet de montage (16) pour l'accrochage à la paroi latérale (3, 4) respective.

3. Système d'entreposage selon l'une des revendications précédentes, **caractérisé en ce que** chaque plaque d'adaptation (12, 13) présente au moins un élément d'encliquetage (24) déplaçable élastiquement pour le blocage par coopération de forme sur la paroi latérale (3, 4) correspondante.

4. Système d'entreposage selon l'une des revendications précédentes, **caractérisé en ce que** chaque plaque d'adaptation (12, 13) présente à une première extrémité (15) le au moins un crochet de montage (16) et à la deuxième extrémité (23) opposée à la première extrémité (15) le au moins un élément d'encliquetage (24).

5. Système d'entreposage selon l'une des revendications précédentes, **caractérisé en ce que** plusieurs rails porteurs (18) sont disposés parallèlement les uns aux autres sur chaque plaque d'adaptation (12, 13), des rails porteurs (18) voisins présentant entre eux une distance qui est supérieure à une distance entre les rails de guidage (11) voisins.

6. Système d'entreposage selon l'une des revendications précédentes, **caractérisé en ce que** les plaques d'adaptation (12, 13) disposées sur le magasin de substrats (2) forment au moins deux compartiments de support (19) superposés de piles de substrats.

7. Système d'entreposage selon l'une des revendications précédentes, **caractérisé en ce que** la plaque d'adaptation (12, 13) respective est réalisée sous forme de tôle d'adaptation et le rail porteur (18) respectif est réalisé sous forme d'au moins une languette de tôle (21) dégagée et pliée vers l'extérieur dans la tôle d'adaptation.

8. Système d'entreposage selon l'une des revendications précédentes, **caractérisé en ce que** le rail porteur (18) respectif peut être fixé ou est fixé de manière amovible à la plaque d'adaptation (12, 13) respective.

9. Système d'entreposage selon l'une des revendications précédentes, **caractérisé en ce qu'**au moins un moyen de retenue (22) déplaçable élastiquement, en particulier déformable, pour une pile de substrats est associé au rail porteur (18) respectif.

10. Système d'entreposage selon l'une des revendications précédentes, **caractérisé en ce qu'**au moins une paroi latérale (4) du magasin de substrats est montée de manière à pouvoir être déplacée de telle sorte qu'une largeur libre entre les parois latérales (3, 4) peut être modifiée.

11. Système d'entreposage selon l'une des revendications précédentes, **caractérisé en ce que** chaque paroi latérale (3, 4) présente au moins une ouverture ou un logement pour au moins un crochet de montage (16).

12. Système d'entreposage selon l'une des revendications précédentes, **caractérisé en ce que** chaque paroi latérale (3, 4) comporte au moins un élément d'encliquetage antagoniste destiné à coopérer avec l'élément d'encliquetage (24) de la plaque d'adaptation (12, 13).

13. Système d'entreposage selon l'une des revendications précédentes, **caractérisé en ce que** l'au moins un élément d'encliquetage (24) de la plaque d'adaptation (12, 13) est formé d'une seule pièce avec la plaque d'adaptation (12, 13).

14. Système d'entreposage selon l'une des revendications précédentes, **caractérisé en ce que** l'au moins un crochet de montage (16) est formé d'une seule pièce avec la plaque d'adaptation (12, 13).
